(19) Europäisches Patentamt
European Patent Office
Office européen des brevets

(11) EP 1 401 183 B1

(12) # FASCICULE DE BREVET EUROPEEN

(45) Date de publication et mention de la délivrance du brevet:
**08.06.2005 Bulletin 2005/23**

(51) Int Cl.$^7$: **H04M 9/08**, H04B 3/23, H04R 29/00

(21) Numéro de dépôt: **03020042.2**

(22) Date de dépôt: **10.09.1996**

(54) **Procédé et dispositif d'annulation d'echo**

Verfahren und Vorrichtung zur Echokompensation

Method and device for echo cancellation

(84) Etats contractants désignés:
**DE GB IT**

(30) Priorité: **13.09.1995 FR 9510714**
**26.04.1996 FR 9605312**

(43) Date de publication de la demande:
**24.03.2004 Bulletin 2004/13**

(62) Numéro(s) de document de la (des) demande(s) initiale(s) en application de l'article 76 CBE:
**96401930.1 / 0 767 569**

(73) Titulaire: **FRANCE TELECOM**
**75015 Paris (FR)**

(72) Inventeurs:
- **Scalart, Pascal**
**22300 Ploubezre (FR)**
- **Duhamel, Pierre**
**92130 Issy les Moulineaux (FR)**
- **Benamar, Abdelkrim**
**77500 Chelles (FR)**

(74) Mandataire: **Loisel, Bertrand**
**Cabinet Plasseraud**
**65/67 rue de la Victoire**
**75440 Paris Cedex 09 (FR)**

(56) Documents cités:
**GB-A- 2 208 983**
**US-A- 4 513 177**
**US-A- 4 901 346**

EP 1 401 183 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne un procédé et un dispositif d'annulation adaptative d'écho.

L'essor actuel des télécommunications dans le domaine du grand public, et plus particulièrement des radiocommunications avec les mobiles, amène les concepteurs de ces systèmes à mettre en oeuvre des solutions techniques optimales en termes de confort d'utilisation.

Dans ce sens, les équipes industrielles de Recherche et de Développement sont fréquemment confrontées à des problèmes d'identification adaptative de systèmes. Parmi ces problèmes, on peut citer, dans le cadre des radiocommunications avec les mobiles, la problématique liée à l'égalisation des canaux de propagation et à l'annulation d'écho acoustique pour la radiotéléphonie mains-libres.

Ces problèmes d'identification de systèmes sont souvent résolus par l'utilisation de techniques de traitement du signal intégrant des procédés d'identification adaptatives. Un autre exemple d'état de la technique est divulgué dans le document US-A-4 513 177. Mais jusqu'à présent, aucun de ces dispositifs ne permet de s'ajuster automatiquement aux conditions de bruit environnant.

L'utilisation de telles techniques adaptatives d'identification de systèmes présente un inconvénient majeur qui réside dans la forte corrélation entre les performances atteintes et le choix des paramètres de contrôle leur étant associés. Ce choix est d'autant plus critique lorsque l'environnement d'utilisation de ces dispositifs évolue au cours du temps, comme cela peut être le cas, par exemple, pour l'annulation d'écho acoustique dans le contexte des radiocommunications avec les mobiles.

Les contraintes de coût poussent souvent les concepteurs d'annuleurs d'écho à concentrer leurs efforts sur des algorithmes de variation de gains, qui sont moins complexes que les algorithmes d'identification adaptative. Mais, jusqu'à présent, aucun dispositif à variation de gains ne permet de s'ajuster automatiquement aux conditions de bruit environnant sans utiliser des mécanismes de détection d'activité vocale.

Dans un annuleur d'écho à gains variables, un gain en réception est appliqué au signal direct avant qu'il soit appliqué au haut-parleur (entrée du système générateur d'écho), et un gain en émission est appliqué au signal capté par le microphone (sortie du système générateur d'écho) pour former le signal de retour. Des détecteurs d'activité vocale en réception (DAVR) et en émission (DAVE), ainsi qu'un détecteur de double parole (DDP) fournissent les informations nécessaires aux modules calculant les gains en émission et en réception. Ainsi, lorsque le locuteur distant parle (détection par DAVR), le gain en émission est diminué afin d'atténuer l'écho. En cas de prise de parole par le locuteur local (détection par DAVE), cette contrainte sur le gain en émission est relâchée, et le gain en réception est diminué. En cas de double parole (les deux locuteurs parlent simultanément ; phénomène détecté par DDP), un comparateur détermine le locuteur dont le niveau est le plus élevé et privilégie son sens d'émission, ou bien un réglage intermédiaire des gains en émission et en réception est établi.

Ces méthodes classiques sont mises en défaut dans trois situations importantes :

- pour des terminaux à fort couplage, la variation de gain requise rend la conversation de type quasi alternée. Cet alternat potentiel peut provoquer la troncature des débuts et des fins de mots, nuisant considérablement à l'intelligibilité de la conversation.
- dans un environnement fortement bruité (contexte mobile par exemple), le comparateur peut rester bloqué sur un sens de transmission, rendant ainsi la communication unilatérale. Dans un tel environnement, le locuteur distant peut aussi percevoir des variations importantes du niveau de bruit nuisant fortement à son confort d'écoute.
- les dispositifs de détection d'activité vocale et de double parole ne sont pas d'une parfaite fiabilité, en particulier en situation fortement bruitée. Un tel manque de fiabilité peut conduire à des calculs de gains erronés, réduisant la qualité de la conversation.

Un but de la présente invention est de proposer un processus de suppression d'écho basé sur une variation de gains adaptative, qui en améliore les performances et en réduise la complexité.

L'invention propose, ainsi un procédé d'annulation d'écho tel qu'énoncé dans la revendication 1.

La variable d'adaptation $\mu_t$ rend compte des conditions de parole, d'écho et de bruit d'une manière appropriée pour déterminer les valeurs des gains. Si la puissance $P1_t$ est inférieure au seuil, il n'y a normalement pas de signal d'écho significatif, la variable $\mu_t$ pouvant alors être nulle. En situation de simple écho, la puissance du signal d'observation est inférieure à M fois la puissance du signal d'entrée, où M est un majorant du module carré de la fonction de transfert du système à générateur d'écho. Dans ce cas, la variable $\mu_t$ est proche de sa valeur maximale a/(c+d.M). En présence d'écho, de bruit et de parole locale (double parole), la puissance $P2_t$ devient supérieure, voire très supérieure, à la puissance $P1_t$, de sorte que $\mu_t$ tend vers 0.

La prise en compte de cette variable d'adaptation $\mu_t$ permet ainsi de se dispenser des détecteurs d'activité vocale et de double parole qui compliquent les annuleurs d'écho connus reposant sur le principe des gains adaptatifs.

De préférence, les gains en réception $Gr_t$ et en émission $Ge_t$ sont déterminés de façon récursive sous la forme :

$$Ge_t = \gamma.Ge_{t-1}+(1-\gamma).f(\mu_t)$$

$$Gr_t = 1-\delta Ge_t$$

où $Ge_{t-1}$ désigne la valeur du gain en émission à l'instant de calcul précédent, $f(\mu_t)$ désigne une fonction décroissante de la variable d'adaptation $\mu_t$, et $\gamma$ et $\delta$ désignent des constantes positives inférieures à 1.

Les gains en émission et en réception sont ainsi lissés au moyen d'un facteur d'oubli $\gamma$, ce qui permet de contrôler la réactivité du système. Cela contribue aussi à réduire le risque de troncature des débuts et des fins de mots.

Un autre aspect de la présente invention concerne un annuleur d'écho tel qu'énoncé dans la revendication 4.

D'autres particularités et avantages de la présente invention apparaîtront dans la description ci-après d'exemples de réalisation préférés mais non limitatifs, en référence aux dessins annexés, dans lesquels :

- la figure 1 est un schéma synoptique d'une forme de réalisation d'un annuleur d'écho selon l'invention ; et
- la figure 2 est un organigramme d'un processus d'adaptation de gains selon l'invention.

La figure 1 montre un dispositif mettant en oeuvre la présente invention, constitué par exemple par un poste téléphonique mains libres. On suppose que ce poste reçoit et émet des signaux numériques $x_t$, $y'_t$ appelés respectivement signal direct et signal de retour (dans le cas de communications analogiques, des convertisseurs appropriés sont prévus pour que les signaux $x_t$ et $y'_t$ soient disponibles sous forme numérique, l'indice t=0,1,2,... désignant les instants d'échantillonnage successifs).

Dans l'exemple représenté, le poste mains libres comporte un haut-parleur 11 et un microphone 13 faisant partie d'un système 14 générateur d'écho.

Un signal d'entrée $x'_t$ est obtenu en appliquant un gain en réception $Gr_t$ au signal direct $x_t$ au moyen d'un multiplieur 66. Le signal d'entrée $x'_t$ est converti en analogique par un convertisseur 68 et amplifié avant d'être appliqué au haut-parleur 11.

Le signal capté par le microphone 13 comprend de façon générale des composantes d'écho $z_t$ provenant du signal émis par le haut-parleur 11, et des composantes d'origine locale $b_t$ pouvant comprendre du bruit et/ou du signal utile (parole du locuteur local). Ce signal issu du microphone 13 est amplifié et numérisé par le convertisseur 70 pour produire un signal numérique d'observation $y_t$.

Un gain en émission $Ge_t$ est appliqué au moyen d'un multiplieur 72 au signal d'observation $y_t$ pour produire le signal de retour $y'_t$.

Pour déterminer les gains en réception et en émission, l'annuleur d'écho comprend deux unités 74, 76 d'estimation de puissances instantanées, une unité 78 de calcul d'une variable d'adaptation $\mu_t$ et une unité 80 de calcul des gains. Dans le cas représenté sur la figure 1, l'estimation $P1_t$ calculée par l'unité 74 est l'estimation de la puissance du signal d'entrée $x'_t$, et l'estimation $P2_t$ calculée par l'unité 76 est l'estimation de la puissance du signal d'observation $y_t$.

Pour estimer la puissance $P1_t$ du signal d'entrée $x'_t$ à un instant t, l'unité 74 utilise une fenêtre exponentielle dont la constante de temps est notée $\lambda_1$ ($0 \le \lambda_1 < 1$) :

$$P1_t = \lambda_1.P1_{t-1} + x'^2_t \quad (18)$$

où

$$P1_t = \lambda_1.P1'_{t-1} + (1-\lambda_1)\, x'^2_t \quad (18bis)$$

où $x'_t$ représente l'échantillon du signal d'entrée à l'instant t.

Le même type de fenêtre exponentielle peut être utilisé par l'unité 76 pour calculer l'estimation $P2_t$. Si $P2_t$ représente une estimation de la puissance du signal d'observation $y_t$, celle-ci est donnée par :

$$P2_t = \lambda_2.P2_{t-1} + y^2_t \quad (19)$$

ou

$$P2_t = \lambda_2.P2_{t-1} + (1-\lambda_2)\, y^2_t \quad (19bis)$$

où $y_t$ est l'échantillon du signal d'entrée à l'instant t et $0 \le \lambda_2 < 1$ ($\lambda_2$ égal ou différent de $\lambda_1$).

L'étape 50 sur la figure 2 représente les opérations effectuées par les unités 74 et 76 (cas des formules (18bis) et (19bis)).

L'unité 78 calcule, sur la base des estimations $P1_t$ et $P2_t$, une variable d'adaptation $\mu_t$ utilisée pour déterminer des valeurs de gains. L'unité 78 exécute ainsi les étapes 51 à 53 représentées sur la figure 2. Elle détermine d'abord si l'estimation de puissance $P1_t$ est supérieure à un seuil T (pouvant être fixe ou adaptatif). Si $P1_t > T$, alors la variable d'adaptation $\mu_t$ est prise égale à 0. Sinon, elle est calculée selon :

$$\mu_t = \frac{a}{c+d\,.\,P2_t/P1_t}$$

où a, c et d désignent des constantes positives.

L'unité 80 calcule alors, en fonction de la variable $\mu_t$, les gains $Gr_t$ et $Ge_t$ fournis aux multiplieurs 66, 72. Dans une première phase, l'unité 80 calcule une grandeur f sous la forme d'une fonction décroissante f ($\mu_t$) de la variable d'adaptation $\mu_t$. Dans l'exemple illustré sur la figure 2 (étapes 54 à 58), cette fonction f($\mu_t$) vaut 1 si la variable d'adaptation $\mu_t$ est inférieure à un premier seuil T1, $\beta(1-\alpha.\mu_t)$ si la variable d'adaptation $\mu_t$ est supérieure à un second seuil T2, et $1-\alpha.\mu_t$ si la variable d'adaptation $\mu_t$ est comprise entre les seuils T1 et T2. Les paramètres $\alpha$ et $\beta$ sont des constantes positives. Les seuils T1 et T2 peuvent être fixes ou adaptatifs. La constante $\beta$, généralement inférieure à 1, permet d'accentuer les petites valeurs de l'a variable $\mu_t$, ce qui permet une plus grande souplesse dans le choix des paramètres a, c et d.

Une fenêtre exponentielle permet ensuite de calculer le gain en émission $Ge_t$ sous forme d'une version lissée dans le temps de la grandeur f précédemment calculée. Ainsi, à l'étape 59, l'unité 80 calcule le gain en émission $Ge_t$ à l'instant t sous la forme

$$Ge_t = \gamma.Ge_{t-1}+(1-\gamma).f,$$

où $\gamma$ est un facteur d'oubli compris entre 0 et 1. Le gain en réception $Gr_t$ à l'instant t est également calculé selon

$$Gr_t = 1-\delta.Ge_t,$$

$\delta$ étant une constante comprise entre 0 et 1.

Avec le mode de calcul ci-dessus, les gains en réception et en émission sont directement liés à l'énergie de l'écho acoustique, ce qui permet d'atténuer l'écho de manière adaptative et de réduire le risque de troncature des débuts et fins de mots.

En outre, la plage de variation du gain en émission $Ge_t$ est une fonction décroissante du niveau de bruit, ce qui permet de réduire considérablement les risques de variation brutale du niveau de bruit perçu par le locuteur distant.

On note que ces avantages ont été obtenus sans recourir à des détecteurs d'activité vocale ou de double parole, qui sont des éléments complexes et de fiabilité parfois insuffisante dans les annuleurs d'écho connus.

En pratique, l'annuleur d'écho à gains adaptatifs selon l'invention peut être réalisé en programmant un processeur spécialisé dans le traitement du signal (DSP) comme il est usuel. Il peut être également réalisé au moyen d'un circuit intégré spécifique (ASIC) dédié à cette application.

Bien entendu, si la prise de son utilise plusieurs microphones et/ou si la restitution de son utilise plusieurs haut-parleurs, le "signal d'entrée" et le "signal d'observation" dont les puissances sont estimées peuvent être constituées par des combinaisons linéaires des signaux mesurés par les microphones ou adressés aux haut-parleurs.

Par ailleurs, moyennant un éventuel ajustement des constantes utilisées, l'estimation $P1_t$ calculée par l'unité 74 peut correspondre à la puissance du signal direct $x_t$ et non à celle du signal d'entrée $x'_t$, et l'estimation $P2_t$ calculée par l'unité 76 peut correspondre à la puissance du signal de retour $y'_t$ et non à celle du signal d'observation $y_t$, comme schématisé par les flèches en pointillés sur la figure 1.

Les inventeurs ont pu vérifier les bonnes performances du procédé d'adaptation des gains selon l'invention dans un annuleur d'écho. A titre d'exemple illustratif, le procédé a montré de bonnes performances en présence d'écho seul dans le silence et dans le bruit, et en présence de double parole, avec les valeurs numériques ci-dessous :

- les différents signaux numériques sont échantillonnés sur 16 bits à 8 kHz ;
- $\lambda_1$=0,9375, et $\lambda_2$=0,9961 (étape 50) ;
- T=100 000 (étape 51) ;
- a=1, c=2 et d=4 (étape 53) ;
- $\alpha$=2, $\beta$=0,1, T1=0,2 et T2=0,25 (étapes 54 à 58) ;
- $\gamma$=0,9375 et $\delta$=0 (étape 59).

## Revendications

1. Procédé d'annulation d'écho pour atténuer dans un signal de retour ($y'_t$) des composantes d'écho d'un signal direct ($x_t$), dans lequel on applique un gain en réception ($Gr_t$) au signal direct pour produire un signal d'entrée ($x'_t$) émis dans un système générateur d'écho (14), et on applique un gain en émission ($Ge_t$) à un signal d'observation ($y_t$) issu du système générateur d'écho pour produire ledit signal de retour, **caractérisé en ce qu'**on détermine les gains en réception et en émission ($Gr_t$, $Ge_t$) sur la base d'une variable d'adaptation $\mu_t$ calculée, à un instant où une estimation $P1_t$ de la puissance du signal direct ($x_t$) ou du signal d'entrée ($x'_t$) est supérieure à un seuil prédéterminé (T), sous la forme :

$$\mu_t = \frac{a}{c+d\,,\,P2_t\,/P1_t}$$

où a, c et d désignent, des constantes positives, et $P2_t$ désigne une estimation à l'instant considéré de la puissance du signal d'observation ($y_t$) ou du signal de retour ($y'_t$).

2. Procédé selon la revendication 1, **caractérisé en ce que** les gains en réception $Gr_t$ et en émission $Ge_t$ sont déterminés de façon récursive sous la forme :

$$Ge_t = \gamma.Ge_{t-1}+(1-\gamma)\ .f(\mu_t)$$

$$Gr_t= 1-\delta Ge_t$$

où $Ge_{t-1}$ désigne la valeur du gain en émission à l'instant de calcul précédent, $f(\mu_t)$ désigne une fonction décroissante de la variable d'adaptation $\mu_t$, et $\gamma$ et $\delta$ désignent des constantes positives inférieures à 1.

3. Procédé selon la revendication 2, **caractérisé en ce que** la fonction $f(\mu_t)$ vaut 1 si la variable d'adaptation $\mu_t$ est inférieure à un premier seuil (T1), $\beta(1-\alpha.\mu_t)$ si la variable d'adaptation $\mu_t$ est supérieure à un second seuil (T2), $\alpha$ et $\beta$ désignant des constantes positives, et $1-\alpha.\mu_t$ si la variable d'adaptation $\mu_t$ est comprise entre les premier et second seuils (T1,T2).

4. Annuleur d'écho pour atténuer dans un signal de retour ($y'_t$) des composantes d'écho d'un signal direct ($x_t$), comprenant des premiers moyens d'application de gain (66) pour appliquer un gain en réception ($Gr_t$) au signal direct et produire un signal d'entrée ($x'_t$) émis dans un système générateur d'écho (14), et des seconds moyens d'application de gain (72) pour produire ledit signal de retour par application d'un gain en émission ($Ge_t$) à un signal d'observation ($y_t$) issu du système générateur d'écho, **caractérisé en ce qu'**il comprend en outre des moyens de calcul (74,76,78,80) pour déterminer les gains en réception et en émission ($Gr_t$, $Ge_t$) sur la base d'une variable d'adaptation $\mu_t$ calculée, à un instant où une estimation $P1_t$ de la puissance du signal direct ($x_t$) ou du signal d'entrée ($x'_t$) est supérieure à un seuil prédéterminé (T), sous la forme :

$$\mu_t = \frac{a}{c+d\ .\ P2_t\ /P1_t}$$

où a, c et d désignent des constantes positives, et $P2_t$ désigne une estimation à l'instant considéré de la puissance du signal d'observation ($y_t$) ou du signal de retour ($y'_t$).

5. Annuleur d'écho selon la revendication 4, **caractérisé en ce que** les moyens de calcul (80) déterminent de façon récursive les gains en réception $Gr_t$ et en émission $Ge_t$ sous la forme :

$$Ge_t = \gamma.Ge_{t-1}+(1-\gamma)\ .f(\mu_t)$$

$$Gr_t= 1-\delta Ge_t$$

où $Ge_{t-1}$ désigne la valeur du gain en émission à l'instant de calcul précédent, $f(\mu_t)$ désigne une fonction décroissante de la variable d'adaptation $\mu_t$, et $\gamma$ et $\delta$ désignent des constantes positives inférieures à 1.

6. Annuleur d'écho selon la revendication 5, **caractérisé en ce que** la fonction $f(\mu_t)$ vaut 1 si la variable d'adaptation $\mu_t$ est inférieure à un premier seuil (T1), $\beta(1-\alpha.\mu_t)$ si la variable d'adaptation $\mu_t$ est supérieure à un second seuil (T2), $\alpha$ et $\beta$ désignant des constantes positives, et $1-\alpha.\mu_t$ si la variable d'adaptation $\mu_t$ est comprise entre les premier et second seuils (T1,T2).

**Patentansprüche**

1. Verfahren zur Echounterdrückung zum Dämpfen von Echokomponenten eines direkten Signals ($x_t$) in einem Rückgabesignal ($y'_t$), wobei beim Verfahren eine Empfangsverstärkung ($Gr_t$) am direkten Signal angewendet wird, um ein in einem Echogeneratorsystem (14) ausgesendetes Eingangssignal ($x'_t$) zu erzeugen, und wobei eine Sendeverstärkung ($Ge_t$) an einem vom Echogeneratorsystem ausgegebenen Beobachtungssignal ($y_t$) angewendet wird, um das Rückgabesignal zu erzeugen, **dadurch gekennzeichnet, dass** die Empfangs- und die Sendeverstärkung ($Gr_t$, $Ge_t$) zu einem Zeitpunkt, an dem eine Schätzung $P1_t$ der Leistung des direkten Signals ($x_t$) oder des Eingangssignals ($x'_t$) größer ist als ein vorbestimmter Schwellwert (T), auf der Basis einer Adaptionsvariable $\mu_t$ bestimmt werden, die in folgender Form berechnet wird:

$$\mu_t = \frac{a}{c+d\ .\ P2_t\ /P1_t}$$

worin a, c und d positive Konstanten bezeichnen, und $P2_t$ eine Schätzung der Leistung des Beobachtungssignals ($y_t$) oder des Rückgabesignals ($y'_t$) zum betrachteten Zeitpunkt bezeichnet.

2. Verfahren nach Anspruch 1, **dadurch gekennzeichnet, dass** die Empfangsverstärkung $Gr_t$ und die Sendeverstärkung $Ge_t$ in rekursiver Weise in folgender Form bestimmt werden:

$$Ge_t = \gamma.Ge_{t-1}+(1-\gamma).f(\mu_t)$$

$$Gr_t= 1-\delta Ge_t$$

worin $Ge_{t-1}$ den Wert der Sendeverstärkung zum vorhergehenden Berechnungszeitpunkt bezeichnet, $f(\mu_t)$ eine abfallende Funktion der Adaptionsvariable $\mu_t$ bezeichnet, und $\gamma$ und $\delta$ positive Konstanten kleiner als 1 bezeichnen.

**3.** Verfahren nach Anspruch 2, **dadurch gekennzeichnet, dass** die Funktion $f(\mu_t)$
1 ist, wenn die Adaptionsvariable $\mu_t$ kleiner ist als ein erster Schwellwert (T1),
$\beta(1-\alpha.\mu_t)$ ist, wenn die Adaptionsvariable $\mu_t$ größer ist als ein zweiter Schwellwert (T2), wobei $\alpha$ und $\beta$ positive Konstanten bezeichnen, und $1-\alpha.\mu_t$ ist, wenn die Adaptionsvariable $\mu_t$ zwischen dem ersten und dem zweiten Schwellwert (T1, T2) enthalten ist.

**4.** Echounterdrückungsvorrichtung zum Dämpfen von Echokomponenten eines direkten Signals ($x_t$) in einem Rückgabesignat ($y'_t$), umfassend erste Verstärkungsanwendungsmittel (66), um eine Empfangsverstärkung ($Gr_t$) am direkten Signal anzuwenden, und um ein in einem Echogeneratorsystem (14) ausgesendetes Eingangssignal ($x'_t$) zu erzeugen, und
zweite Verstärkungsanwendungsmittel (72), um durch Anwenden einer Sendeverstärkung ($Ge_t$) an einem vom Echogeneratorsystem ausgegebenen Beobachtungssignal ($y_t$) das Rückgabesignal zu erzeugen,
**dadurch gekennzeichnet, dass**
es ferner Berechnungsmittel (74, 76, 78, 80) umfasst, um die Empfangs- und die Sendeverstärkung ($Gr_t$, $Ge_t$) zu einem Zeitpunkt, an dem eine Schätzung $P1_t$ der Leistung des direkten Signals ($x_t$) oder des Eingangssignals ($x'_t$) größer ist als ein vorbestimmter Schwellwert (T), auf der Basis einer Adaptionsvariable $\mu_t$ zu bestimmen, die in folgender Form berechnet wird:

$$\mu_t = \frac{a}{c+d\ .\ P2_t\ /P1_t}$$

worin a, c und d positive Konstanten bezeichnen, und $P2_t$ eine Schätzung der Leistung des Beobachtungssignals ($y_t$) oder des Rückgabesignals ($y'_t$) zum betrachteten Zeitpunkt bezeichnet.

**5.** Echounterdrückungsvorrichtung nach Anspruch 4, **dadurch gekennzeichnet, dass** die Berechnungsmittel (80) die Empfangsverstärkung ($Gr_t$) und die Sendeverstärkung ($Ge_t$) in rekursiver Weise in folgender Form berechnen:

$$Ge_t = \gamma.Ge_{t-1}+(1-\gamma).f(\mu_t)$$

$$Gr_t= 1-\delta Ge_t$$

worin $Ge_{t-1}$ den Wert der Sendeverstärkung zum vorhergehenden Berechnungszeitpunkt bezeichnet, $f(\mu_t)$ eine abfallende Funktion der Adaptionsvariable $\mu_t$ bezeichnet, und $\gamma$ und $\delta$ positive Konstanten kleiner als 1 bezeichnen.

**6.** Echounterdrückungsvorrichtung nach Anspruch 5, **dadurch gekennzeichnet, dass** die Funktion $f(\mu_t)$
1 ist, wenn die Adaptionsvariable $\mu_t$ kleiner ist als ein erster Schwellwert (T1),
$\beta(1-\alpha.\mu_t)$ ist, wenn die Adaptionsvariable $\mu_t$ größer ist als ein zweiter Schwellwert (T2), wobei $\alpha$ und $\beta$ positive Konstanten bezeichnen, und
$1-\alpha.\mu_t$ ist, wenn die Adaptionsvariable $\mu_t$ zwischen dem ersten und dem zweiten Schwellwert (T1, T2) enthalten ist.

## Claims

**1.** Process of echo cancellation for attenuating, in a return signal ($y'_t$), echo components of a forward signal ($x_t$), which comprises applying a reception gain ($Gr_t$) to the forward signal so as to produce an input signal ($x'_t$) sent to an echo generator system (14), and applying a transmission gain ($Gt_t$) to an observation signal ($y_t$) emanating from the echo generator system so as to produce said return signal, **characterized in that** the reception and transmission gains ($Gr_t$, $Gt_t$) are determined on the basis of an adaptation variable $\mu_t$ calculated, at an instant at which an estimate $P1_t$ of the power of the forward signal ($x_t$) or of the input signal ($x'_t$) is greater than a predetermined threshold (T), in the form:

$$\mu_t = \frac{a}{c+d.P2_t/P1_t}$$

where a, c and d denote positive constants, and $P2_t$ denotes an estimate at the relevant instant of the power of the observation signal ($y_t$) or of the return signal ($y'_t$).

**2.** Process according to Claim 1, **characterized in that** the reception gain ($Gr_t$) and transmission gain ($Gt_t$) are determined recursively in the form:

$$Gt_t = \gamma.Gt_t\ -1+(1-\gamma).f(\mu_t)$$

$$Gr_t = 1-\delta Gt_t$$

where $Gt_{t-1}$ denotes the value of the transmission gain at the previous calculation instant, $f(\mu_t)$ denotes a decreasing function of the adaptation variable $\mu_t$, and $\gamma$ and $\delta$ denote positive constants less than 1.

**3.** Process according to Claim 2, **characterized in that** the function $f(\mu_t)$ equals 1 if the adaptation variable $\mu_t$ is less than a first threshold (T1), $\beta(1-\alpha.\mu_t)$ if the adaptation variable $\mu_t$ is greater than a second threshold (T2), $\alpha$ and $\beta$ denoting positive constants, and $1-\alpha.\mu_t$ if the adaptation variable $\mu_t$ is between the first and second thresholds (T1, T2).

**4.** Echo canceller for attenuating, in a return signal ($y'_t$), echo components of a forward signal ($x_t$), comprising first gain application means (66) for applying a reception gain ($Gr_t$) to the forward signal and for producing an input signal ($x'_t$) sent to an echo generator system (14), and second gain application means (72) for producing said return signal by applying a transmission gain ($Gt_t$) to an observation signal ($y_t$) emanating from the echo generator system, **characterized in that** it further comprises calculation means (74, 76, 78, 80) for determining the reception and transmission gains ($Gr_t$, $Gt_t$) on the basis of an adaptation variable $\mu_t$ calculated, at an instant at which an estimate $P1_t$ of the power of the forward signal ($x_t$) or of the input signal ($x'_t$) is greater than a predetermined threshold (T), in the form:

$$\mu_t = \frac{a}{c+d.P2_t/P1_t}$$

where a, c and d denote positive constants, and $P2_t$ denotes an estimate at the relevant instant of the power of the observation signal ($y_t$) or of the return signal ($y'_t$).

**5.** Echo canceller according to Claim 4, **characterized in that** the calculation means (80) recursively determine the reception gain $Gr_t$ and transmission gain $Gt_t$ in the form:

$$Gt_t = \gamma.Gt_{t-1}+(1-\gamma).f(\mu_t)$$

$$Gr_t = 1-\delta.Gt_t$$

where $Gt_{t-1}$ denotes the value of the transmission gain at the previous calculation instant, $f(\mu_t)$ denotes a decreasing function of the adaptation variable $\mu_t$, and $\gamma$ and $\delta$ denote positive constants less than 1.

**6.** Echo canceller according to Claim 5, **characterized in that** the function $f(\mu_t)$ equals 1 if the adaptation variable $\mu_t$ is less than a first threshold (T1), $\beta(1-\alpha.\mu_t)$ if the adaptation variable $\mu_t$ is greater than a second threshold (T2), $\alpha$ and $\beta$ denoting positive constants, and $1-\alpha.\mu_t$ if the adaptation variable $\mu_t$ is between the first and second thresholds (T1, T2).

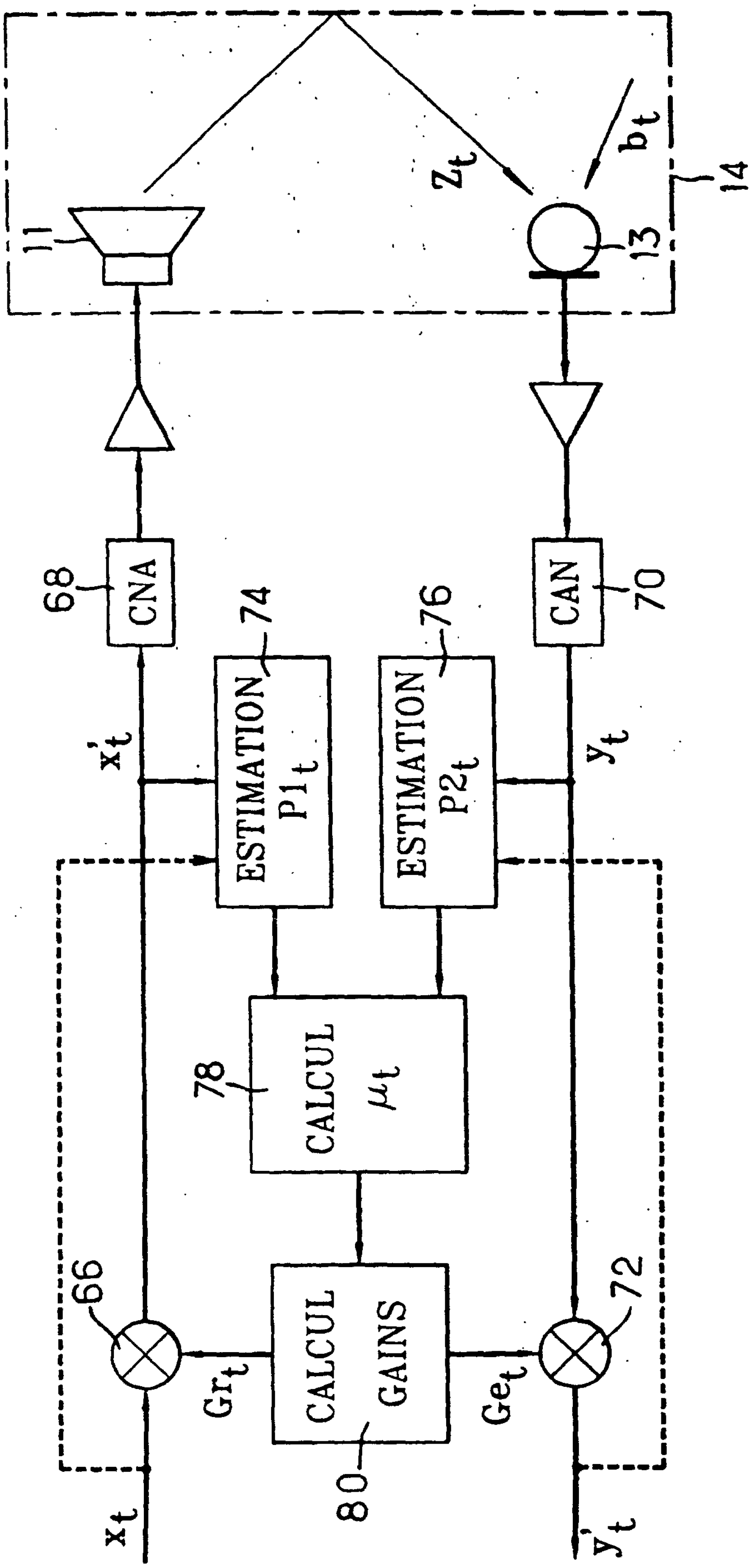
11
13
14
$z_t$
$b_t$
68
CNA
CAN
70
74
ESTIMATION $P1_t$
76
ESTIMATION $P2_t$
$x'_t$
$y_t$
78
CALCUL $\mu_t$
66
72
CALCUL GAINS
80
$Gr_t$
$Ge_t$
$x_t$
$y'_t$

FIG. 1.

FIG.2.

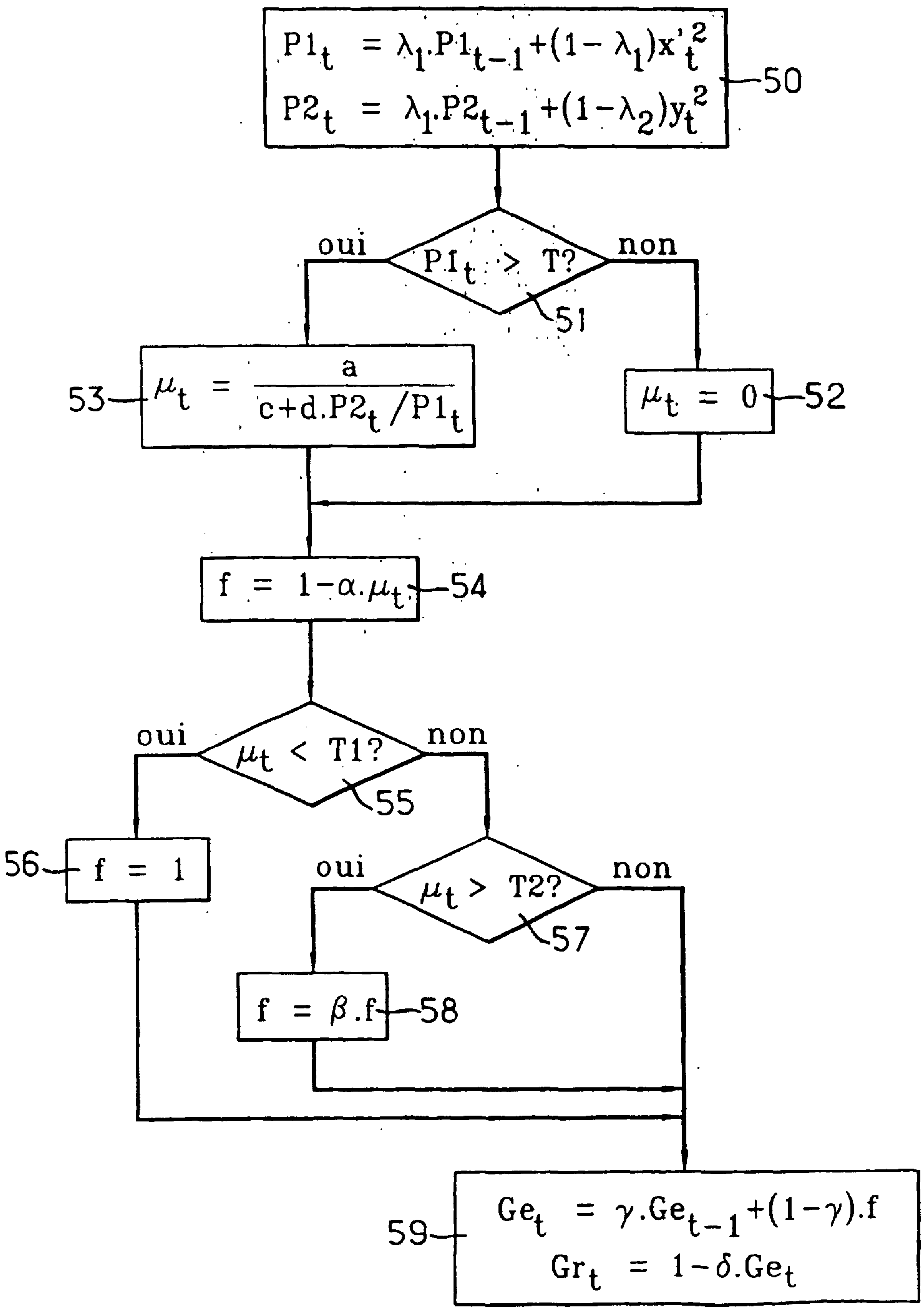
P1t = λ1.P1t-1 + (1-λ1)x't²
P2t = λ1.P2t-1 + (1-λ2)yt²
50
oui
P1t > T?
non
51
μt = a / (c+d.P2t / P1t)
53
μt = 0
52
f = 1-α.μt
54
oui
μt < T1?
non
55
f = 1
56
oui
μt > T2?
non
57
f = β.f
58
Get = γ.Get-1 + (1-γ).f
Grt = 1-δ.Get
59